# FASCICULE DE BREVET EUROPEEN

(11) **EP 3 384 566 B1**
(45) Date de publication et mention de la délivrance du brevet: **07.04.2021**
(21) Numéro de dépôt: 16815577.8
(22) Date de dépôt: 16.11.2016
(51) Int. Cl.: H01T 23/00, H01T 19/04

(54) **DISPOSITIF DE GÉNÉRATION D'IONS**
IONENERZEUGUNGSVORRICHTUNG
ION-GENERATING DEVICE

(30) Priorité: 02.12.2015 FR 1561761
(43) Date de publication de la demande: 10.10.2018
(73) Titulaire: Teqoya, 33730 Villandraut (FR)
(72) Inventeur: BRETON, Jacques, 33600 Pessac (FR); MARCHAND, Renaud, 33730 Villandraut (FR); GUITTON, Pierre, 75020 Paris (FR)
(74) Mandataire: Touroude, Magali Linda
(86) Numéro de dépôt international: PCT/FR2016/052977
(87) Numéro de publication internationale: WO 2017/093630

(56) Documents cités:
- WO-A1-2009/115650
- FR-A1- 2 794 295
- JP-A- 2007 048 682
- US-A- 5 789 749
- US-A1- 2007 006 478

## Description

La présente invention concerne un dispositif de génération d'ions à partir d'un plasma, dispositif présentant une face de rayonnement sur laquelle est disposée au moins une embouchure d'un émetteur de particules formé d'une gaine portée à une première tension située dans le prolongement de ladite embouchure, d'une tige constituée par un matériau électriquement conducteur, insérée dans ladite gaine, tige présentant au niveau de l'embouchure une pointe portée à une tension d'une deuxième polarité, lesdites tensions étant élaborées par un circuit de haute tension.

Il est bien connu que la présence d'ions, de préférence des ions négatifs, tels que celui de l'oxygène négatif (O2-) apporte un effet bénéfique sur la santé des êtres vivants et apporte une contribution à la dépollution de l'air. Dans l'environnement normal d'une agglomération urbaine, une concentration de tels ions est rarement satisfaisante. On a alors songé de créer de manière artificielle ces ions négatifs. On trouve dans le commerce de tels dispositifs. On notera que le document de brevet français n°2 722 923 décrit un tel dispositif qui a la faculté de créer des ions sans générer de l'ozone ou des oxydes d'azote en quantité mesurable.

Dans ce document, la création des ions négatifs s'obtient par la formation d'un plasma naissant à partir d'une pointe portée à une haute tension.

Bien que fonctionnel, ce dispositif connu n'assure pas toujours une création d'ions d'une façon constante, si bien qu'une répétabilité de la performance du dispositif n'a pas pu être obtenue lors de sa fabrication. Il a de plus été noté une forte sensibilité du dispositif aux matériaux constitutifs de l'appareil ;

Le document US5789749 décrit un dispositif selon le préambule de la revendication 1.

Le but de l'invention est donc d'obtenir de façon plus stable et de manière plus sûre ce plasma à partir duquel les ions sont créés.

Pour cela, le dispositif de génération de particules ionisées du genre mentionné dans le préambule est remarquable en ce que qu'il comporte une structure électriquement conductrice située au niveau de la face avant.

Pour avoir une efficacité plus grande, et fonctionner avec tout matériau constitutif de la face avant, cette structure se présente, d'une manière préférentielle mais non limitative, sous la forme d'une grille constituée de segments présentant une forme allongée dont la dimension transversale est inférieure au diamètre des embouchures et étant disposés à proximité desdites embouchures.

La description suivante accompagnée des dessins ci-annexés, le tout donné à titre d'exemple non limitatif, fera bien comprendre comment l'invention peut être réalisée. Dans les dessins :
- la figure 1 montre un dispositif conforme à l'invention,
- la figure 2 montre en vue de profil un émetteur de particules,
- la figure 3 montre une première configuration de la structure proposée par l'invention,
- la figure 4 montre une deuxième configuration de la structure proposée par l'invention,
- la figure 5 montre des modes de réalisation du dispositif de l'invention,
- la figure 6 montre un autre mode de réalisation du dispositif de l'invention.

Sur ces figures, les éléments communs portent tous les mêmes références sur toutes les figures.

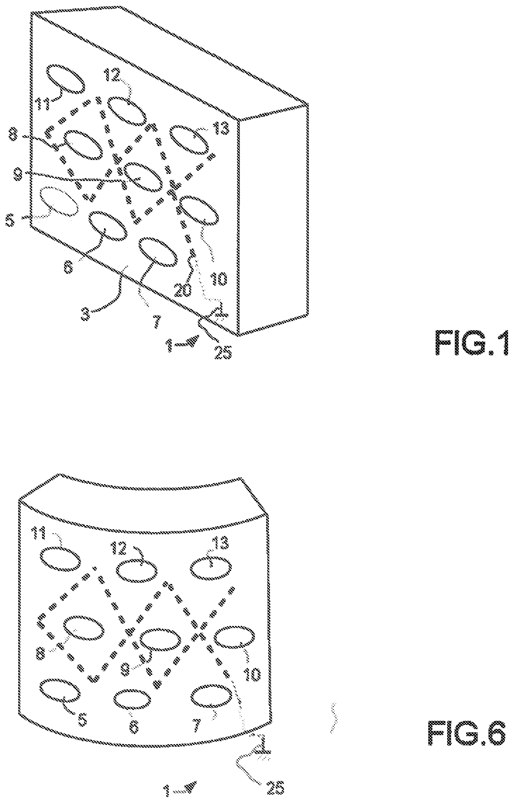

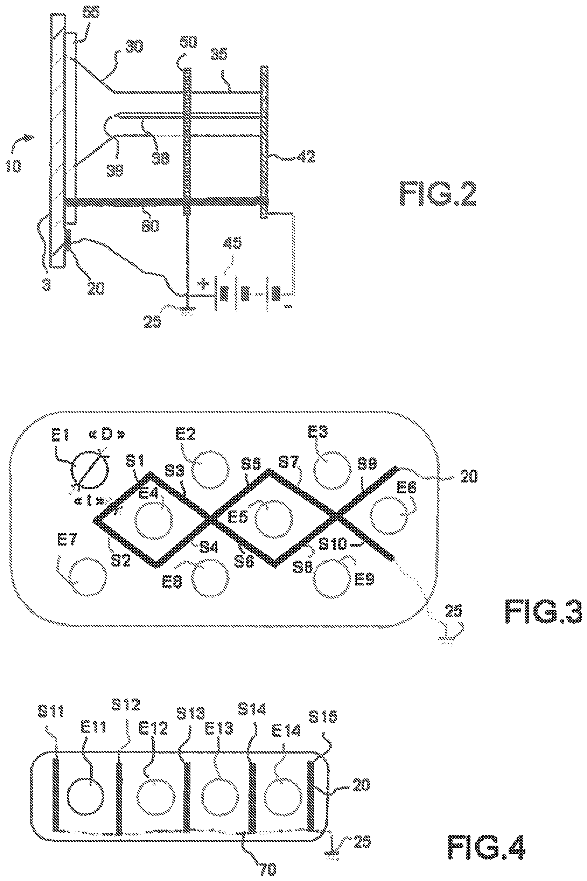

A la figure 1, la référence 1 indique le dispositif de l'invention. Les éléments de ce dispositif sont placés dans un boîtier comportant une face avant de rayonnement 3 dite face de génération d'ions. Sur cette face avant différentes ouvertures 5, 6, 7, 8, 9, 10 11, 12 et 13 sont ménagées. C'est par ces ouvertures que le flux d'ions est diffusé à l'extérieur. Pour cela, ces ouvertures communiquent avec une embouchure d'un émetteur de particules dont le détail est représenté à la figure 2. En pratique, les dispositifs conformes à l'invention comportent entre 4 et 24 émetteurs de particules.

Conformément à l'invention, le dispositif 1 est muni d'une structure 20 faite en un matériau électriquement conducteur. Sur la figure, cette structure 20 est montrée en pointillé pour indiquer qu'elle est disposée à l'arrière de la face avant 3. Cette grille est connectée à la masse 25 du dispositif 1.

La figure 2 montre en vue de profil un émetteur d'ions convenant à l'invention. Cet émetteur est affecté à l'ouverture 10 de la face avant 3. Bien entendu, à chaque ouverture est affecté un émetteur identique. L'émetteur de la figure 2 se compose d'une embouchure 30 de forme conique qui se raccorde à un tube 35 formant une gaine dans laquelle est disposée une tige 38 réalisée en un matériau électriquement conducteur. Cette tige se termine à sa première extrémité en une pointe 39 au niveau de l'embouchure 30 et est connectée électriquement par sa seconde extrémité à une plaque 42 portée à une tension négative engendrée par un générateur haute tension 45. La tension fournie a une valeur telle à créer l'effet corona.

Une plaque 50 munie d'un passage pour entourer la gaine 35 est portée à la tension positive du générateur 45. Cette plaque 50 est donc au potentiel de la masse 25. Il est prévu aussi un plan de sortie 55 se situant à l'embouchure 30. La structure 20 est placée sur la face interne de la face avant 3. Cette structure 20 peut être placée en sandwich entre cette face interne et ce plan de sortie. Il va de soi que les plaques 42 et 50 peuvent être communes à tous les émetteurs que comporte le dispositif de l'invention. Il peut en être de même pour le plan de sortie 55.

En variante, le plan de sortie et la face avant peuvent être combinés de sorte que la structure peut être alors intégrée dans la matière du boîtier. On notera que l'on a également prévu des plots d'assemblage tel que le plot 60 qui maintient les différents éléments de l'émetteur contre la face avant.

Selon une autre variante, ces plots peuvent être utilisés pour fixer la structure 20.

La structure 20, selon un premier mode, est montrée à la figure 3. Ce mode est relatif à un dispositif comportant 9 émetteurs de particules ionisées. Cette structure se compose de plusieurs segments S1 à S10 entourant les 9 embouchures E1 à E9 représentées sur cette figure 3.

Selon un deuxième mode, une autre structure 20 est montrée à la figure 4 relative à un dispositif possédant 4 émetteurs. Dans ce cas, les segments S11 à S15 n'entourent pas les embouchures E11 à E15 disposées en ligne droite mais ils sont placés au voisinage de celles-ci de part et d'autre des embouchures E11 à E15.

Tous les segments sont portés au potentiel de la masse 25. Ceci est assuré par une connexion électrique 70, montrée en pointillé sur cette figure, les reliant à la masse 25. Ces segments sont de forme allongée dont la dimension transversale « t » est bien inférieure au diamètre « D » de l'embouchure. Ceci est montré à la figure 3 relativement à S1 et E1 respectivement.

Il est possible aussi que le réseau des séquences soit continu, c'est-à-dire constitué d'un seul tenant.

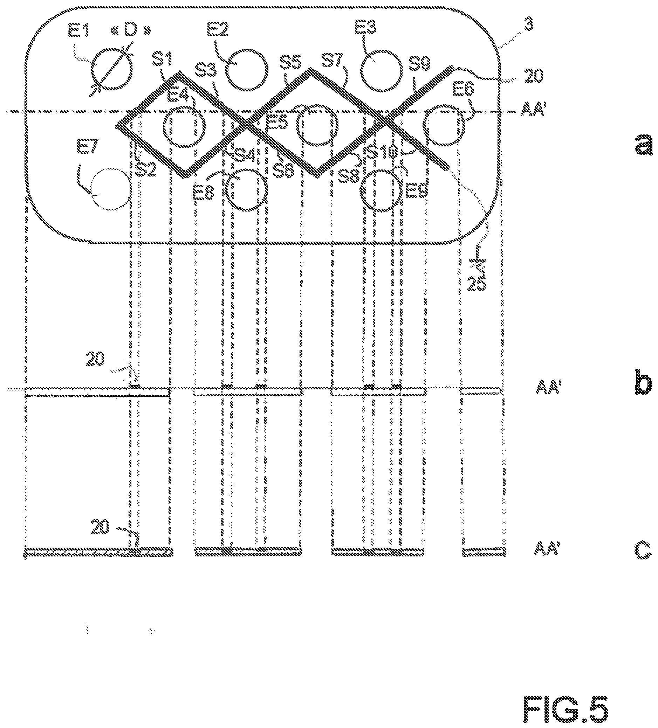

A la figure 5, on montre en variantes de réalisation du dispositif de l'invention, des façons de disposer la structure 20 sur la face avant 3. La figure 5a montre la face avant 3, les figures 5b et 5c montrent la vue en coupe de la plaque avant 3 selon la ligne AA'.

La figure 5b illustre le fait que la structure 20 est collée sur cette face avant 3. Cette structure peut être réalisée selon les techniques de circuit imprimé ou être réalisée par un dépôt d'un matériau conducteur tel qu'un métal ou une couche en matière graphitée.

A la figure 5c, la structure 20 est disposée dans une gorge pratiquée sur cette face avant ce qui apporte une certaine protection à cette structure 20.

La structure ainsi disposée permet de réaliser de façon simple des dispositifs de l'invention ayant un aspect arrondi avec des formes courbées ce qui leur apporte de l'agrément et un attrait pour les utilisateurs (voir la figure 6).

On notera que par l'inversion des polarités du générateur 45, il sera possible de produire des ions positifs.

## Revendications

1. Dispositif de génération de particules ionisées à partir d'un plasma, dispositif présentant une face avant de rayonnement (3) sur laquelle est disposée au moins une embouchure (30,E1..E14) d'un émetteur de particules, l'au moins une embouchure communiquant avec une des ouvertures (5-13) ménagées sur la face de rayonnement (3), l'émetteur de particules étant formé d'une gaine (35) portée à une première tension et située dans le prolongement de ladite embouchure, d'une tige (38) constituée par un matériau électriquement conducteur, insérée dans ladite gaine (35) ladite tige présentant au niveau de l'embouchure une pointe (39) portée à une tension d'une deuxième polarité, **caractérisé en ce qu'**il comporte une structure (20) électriquement conductrice située au niveau de la face avant (3) et **en ce que** ladite structure (20) est formée de segments (S1... S15) de forme allongée placés au voisinage de l'embouchure.

2. Dispositif selon la revendication 1 **caractérisé en ce que** la structure (20) est électriquement connectée à la masse (25) du dispositif.

3. Dispositif selon la revendication 1 ou 2 **caractérisé en ce que** ladite structure (20) est formée de segments (S1 .. S15) de forme allongée entourant lesdites embouchures.

4. Dispositif selon l'une des revendications 1 à 3 **caractérisé en ce que** la dimension transversale («t») desdits segments (S1. S15 .) est inférieure au diamètre (« D ») des embouchures (30, E1 ... E14) et supérieure au rayon de courbure des pointes (39).

5. Dispositif selon l'une des revendications 1 à 4 **caractérisé en ce que** lesdits segments forment un réseau continu c'est-à-dire constitué d'un seul matériau conducteur.

6. Dispositif selon l'une des revendications 1 à 5 **caractérisé en ce que** ladite structure (20) est réalisée au moyen d'un dépôt d'une couche d'un matériau conducteur sur la face avant de rayonnement (3).

7. Dispositif selon l'une des revendications 1 à 6 **caractérisé en ce que** ladite structure (20) est disposée selon des gorges sur la face avant (3).

8. Dispositif selon l'une des revendications 1 à 7 **caractérisé en ce qu'**il présente un aspect arrondi.

## Patentansprüche

1. Vorrichtung zur Erzeugung ionisierter Teilchen aus einem Plasma, wobei die Vorrichtung eine Strahlungsvorderseite (3) aufweist, an der mindestens eine Mündung (30, E1...E14) eines Teilchenemitters angeordnet ist, wobei die mindestens eine Mündung mit einer der auf der Strahlungsfläche (3) vorgesehenen Öffnungen (5-13) in Verbindung steht, wobei der Teilchenemitter aus einer auf eine erste Spannung angehobenen und sich in der Verlängerung der genannten Mündung befindenden Hülle (35), einem aus einem elektrisch leitenden Material bestehenden Stab (38), der in die Hülle (35) eingeführt ist, gebildet ist, wobei der Stab an der Mündung eine Spitze (39) aufweist, die auf eine Spannung einer zweiten Polarität gebracht wird, **dadurch gekennzeichnet, dass** sie eine elektrisch leitende Struktur (20) aufweist, die sich im Bereich der Vorderseite (3) befindet und dass die Struktur (20) aus Segmenten (S1 ...S15) mit länglicher Form gebildet ist, die in der Nähe der Mündung platziert sind.

2. Vorrichtung nach Anspruch 1, **dadurch gekennzeichnet, dass** die Struktur (20) mit der Masse (25) der Vorrichtung elektrisch verbunden ist.

3. Vorrichtung nach Anspruch 1 oder 2, **dadurch gekennzeichnet, dass** die Struktur (20) aus Segmenten (S1...S15) mit länglicher Form gebildet ist, die die Mündungen umgeben.

4. Vorrichtung nach einem der Ansprüche 1 bis 3, **dadurch gekennzeichnet, dass** die Querabmessung ("t") der Segmente (S1... S15) kleiner als der Durchmesser ("D") der Mündungen (30, E1...E14) und größer als der Krümmungsradius der Spitzen (39) ist.

5. Vorrichtung nach einem der Ansprüche 1 bis 4, **dadurch gekennzeichnet, dass** die Segmente ein kontinuierliches Netzwerk bilden, d. h. aus einem einzigen leitfähigen Material bestehen.

6. Vorrichtung nach einem der Ansprüche 1 bis 5, **dadurch gekennzeichnet, dass** die Struktur (20) durch Abscheiden einer Schicht aus einem leitfähigen Material auf der Strahlungsvorderseite (3) hergestellt wird.

7. Vorrichtung nach einem der Ansprüche 1 bis 6, **dadurch gekennzeichnet, dass** die Struktur (20) gemäß Nuten auf der Vorderseite (3) angeordnet ist.

8. Vorrichtung nach einem der Ansprüche 1 bis 7, **dadurch gekennzeichnet, dass** sie ein abgerundetes Aussehen aufweist.

## Claims

1. Device for generating ionized particles from a plasma, the device having a front radiation face (3) on which at least one mouth (30, E1... E14) of a particle emitter is arranged, the at least one mouth communicating with one of the openings (5-13) provided on the radiation face (3), the particle emitter being formed of a sheath (35) which is brought to a first voltage and located in the extension of said mouth, and of a rod (38) which consists of an electrically conductive material and is inserted into said sheath (35), said rod having a tip (39) at the mouth, which tip is brought to a voltage of a second polarity, **characterized in that** it comprises an electrically conductive structure (20) located at the front face (3) and **in that** said structure (20) is formed of segments (S1... S15) of elongated shape placed in the vicinity of the mouth.

2. Device according to claim 1, **characterized in that** the structure (20) is electrically connected to the ground (25) of the device.

3. Device according to either claim 1 or claim 2, **characterized in that** said structure (20) is formed of segments (S1... S15) of elongated shape surrounding said mouths.

4. Device according to one of claims 1 to 3, **characterized in that** the transverse dimension ("t") of said segments (S1... S15) is less than the diameter ("D") of the mouths (30, E1... E14) and greater than the radius of curvature of the tips (39).

5. Device according to one of claims 1 to 4, **characterized in that** said segments form a continuous network, i.e. which consists of a single conductive material.

6. Device according to one of claims 1 to 5, **characterized in that** said structure (20) is produced by depositing a layer of a conductive material on the front radiation face (3).

7. Device according to one of claims 1 to 6, **characterized in that** said structure (20) is arranged in grooves on the front face (3).

8. Device according to one of claims 1 to 7, **characterized in that** said device has a rounded appearance.
